(19) Europäisches Patentamt
European Patent Office
Office européen des brevets

(11) **EP 1 815 594 B1**

(12) **EUROPÄISCHE PATENTSCHRIFT**

(45) Veröffentlichungstag und Bekanntmachung des Hinweises auf die Patenterteilung:
**08.01.2014 Patentblatt 2014/02**

(21) Anmeldenummer: **05814267.0**

(22) Anmeldetag: **18.11.2005**

(51) Int Cl.:
**H03K 17/97** (2006.01)     **F16H 59/04** (2006.01)

(86) Internationale Anmeldenummer:
**PCT/DE2005/002079**

(87) Internationale Veröffentlichungsnummer:
**WO 2006/056170 (01.06.2006 Gazette 2006/22)**

(54) **SCHALTVORRICHTUNG FÜR EIN KRAFTFAHRZEUG**

SHIFTING DEVICE FOR A MOTOR VEHICLE

DISPOSITIF DE CHANGEMENT DE VITESSES POUR VEHICULE AUTOMOBILE

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **24.11.2004 DE 102004056800**

(43) Veröffentlichungstag der Anmeldung:
**08.08.2007 Patentblatt 2007/32**

(73) Patentinhaber: **ZF FRIEDRICHSHAFEN Aktiengesellschaft**
**88038 Friedrichshafen (DE)**

(72) Erfinder:
• **ERSOY, Metin**
  **65396 Walluf (DE)**
• **GÄRTNER, Andreas**
  **28211 Bremen (DE)**
• **REITZ, Peter**
  **88099 Neukirch (DE)**

(56) Entgegenhaltungen:
| | |
|---|---|
| **EP-A2- 0 357 274** | **DE-A1- 19 749 330** |
| **DE-C1- 10 110 738** | **FR-A- 2 768 824** |
| **US-A- 3 331 972** | **US-A- 4 500 867** |
| **US-A- 4 519 266** | **US-A- 4 712 420** |
| **US-A- 4 733 214** | **US-A- 5 850 142** |
| **US-A1- 2002 003 527** | **US-A1- 2002 175 060** |

**Beschreibung**

Die Erfindung betrifft eine Schaltvorrichtung für ein Kraftfahrzeug, mit einer Halterung, einem über ein Gelenk schwenkbar an der Halterung gelagerten Wählhebel und einer einen Signalgeber und zwei Sensoren aufweisenden Winkelmessvorrichtung.

Die bislang übliche elektronische Schaltstellungserkennung von Wählhebeln mit Hilfe von Positionssensoren, z. B. nach dem Hall-Prinzip, ist unflexibel hinsichtlich der heute gebräuchlichen Wählhebelführung in mehreren Gassen und Zwischenstellungen. Häufig wird für jede Wählhebelstellung ein Sensor vorgesehen, wobei viele Sensoren zu höheren Kosten und verringerter Zuverlässigkeit führen.

US 4,519,266 offenbart eine Schaltvorrichtung mit einer Halterung, einem über ein Gelenk schwenkbar an der Halterung gelagerten Wählhebel und eine Schaltpositionserfassungsvorrichtung mit mehreren Signalgebern für eine erste Schwenkrichtung des Wählhebels sowie einem Signalgeber für eine zweite Schwenkrichtung des Wählhebels. Den Signalgebern sind für die jeweiligen Schaltpositionen jeweils verschiedene an festen Orten befestigte Sensoren zugeordnet. Bei Erreichen oder Überstreichen des Sensors durch die Signalgeber wird jeweils ein Signal abgegeben, mit dessen Hilfe ein Kraftfahrzeuggetriebe gesteuert werden kann. Die Signalgeber sind an am Wählhebel befestigten Bauteilen angeordnet, wobei die Signalgeber zum Gelenk, welches durch die Schwenkachsen gebildet wird, beabstandet angeordnet sind.

US 4,733,214 betrifft kontaktlose Steuergeräte für unterschiedliche Einsatzgebiete wie beispielsweise in Landwirtschaftsfahrzeugen. Das Dokument offenbart eine als Joystick bekannte Steuervorrichtung mit einer Halterung, einen über ein Gelenk schwenkbar an der Halterung gelagerten Schal- bzw. Steuerhebel sowie eine einen Signalgeber und zwei Sensoren aufweisende Winkelmessvorrichtung, die im Gelenk angeordnet ist.

EP 0 357 274 offenbart eine als Joystick bekannte Steuervorrichtung, welche als Schaltvorrichtung zur Steuerung von Schaltgetrieben in Kraftfahrzeugen verwendbar ist.

Aus der DE 197 49 330 C2 ist eine Schalterfassungsvorrichtung bekannt, mit einem Schaltmittel, einem magnetischen Signalgeber und einer Signalempfängeranordnung. Als Signalempfänger ist ein zumindest zwei magnetoelektrische Wandler umfassendes Sensorarray vorgesehen, wobei als Wandler magnetoresistive Sensorelemente eingesetzt werden können. Der an die Bewegung des Schaltmittels gekoppelte Signalgeber ist ein Magnet, der mit den magnetoresistiven Sensorelementen zusammenwirkt, wobei die Sensorelemente in unterschiedlichen, orthogonal zueinander stehenden Ebenen angeordnet sind. Das Schaltmittel ist schwenkbar gelagert und weist beidseitig der Lagerung zwei Hebelarme auf, wobei der Magnet und die Sensorelemente im Bereich eines freien Endes von einem der Hebelarme angeordnet sind.

Nachteilig an dieser Anordnung ist, dass der Magnet bei einer Betätigung des Schaltmittels relativ große Wege zurücklegt, so dass auch der Signalempfänger einen relativ großen Raum einnehmen muss.

Aufgabe der Erfindung ist es, eine verbesserte Schaltvorrichtung bereitzustellen.

Diese Aufgabe wird erfindungsgemäß mit einer Schaltvorrichtung nach Anspruch 1 gelöst. Bevorzugte Weiterbildungen sind in den Unteransprüchen gegeben.

Die erfindungsgemäße Schaltvorrichtung oder Wählhebelanordnung für ein Kraftfahrzeug weist eine Halterung, einen über ein Gelenk schwenkbar an der Halterung gelagerten Wählhebel und eine einen Signalgeber und zwei Sensoren umfassende Winkelmessvorrichtung auf, wobei die Winkelmessvorrichtung in dem Gelenk angeordnet und mit einer mit einem Kraftfahrzeuggetriebe verbundenen Steuereinrichtung elektrisch verbunden ist.

Dadurch dass die Winkelmessvorrichtung in das Gelenk integriert ist, sind der Signalgeber und die Sensoren relativ nahe an der oder den Schwenkachsen des Wählhebels angeordnet, so dass nur sehr kleine Wege bzw. Wegänderungen von der Winkelmessvorrichtung erfasst werden müssen. Somit kann die Winkelmessvorrichtung insgesamt sehr klein und kompakt aufgebaut werden kann. Ferner schützt das Gelenk die Winkelmessvorrichtung vor Verunreinigungen.

Als besonders störunanfällig haben sich auf Magnetfeldmessungen basierende Winkelmessvorrichtungen erwiesen, so dass der Signalgeber als Magnet und die Sensoren als magnetfeldempfindliche Sensoren, wie z. B. Hall-Effekt-Sensoren, ausgebildet sein können. Bevorzugt sind die magnetfeldempfindlichen Sensoren aber als magnetoresistive Sensoren ausgebildet, die im Unterschied zu Hall-Sensoren eine Zweipunktmessung je Sensor ermöglichen, so dass der Beschaltungsaufwand reduziert werden kann. Ferner ist durch die Verwendung magnetoresistiver Sensoren regelmäßig eine Erfassung größerer räumlicher Winkel möglich als mit derselben Anzahl von Hall-Sensoren.

Die beiden Sensoren können an unterschiedlichen Orten in dem Gehäuse vorgesehen sein. Ferner können die beiden Sensoren einen rechten Winkel miteinander einschließen und z.B. über Kreuz angeordnet oder L-förmig zueinander ausgerichtet sein, wobei die sensitiven Flächen der beiden Sensoren bevorzugt senkrecht zueinander verlaufen, so dass eine Bestimmung von zwei aufeinander senkrecht stehenden Winkeln vereinfacht ist.

Es ist möglich, die beiden Sensoren separat voneinander anzuordnen. Bevorzugt sind die beiden Sensoren aber zu einer Sensorbaugruppe zusammengefasst, wodurch der Montageaufwand für die Sensoren reduzierbar ist. Insbesondere sitzen die Sensoren dabei auf einer gemeinsamen Platine. Auch die Steuereinrichtung kann in die Sensorbaugruppe integriert werden und gegebenenfalls an der Platine angeordnet bzw. festgelegt sein.

Das Gelenk ist als Kugelgelenk ausgebildet, so dass die möglichen Schwenkrichtungen für den Wählhebel durch das Gelenk gar nicht oder lediglich geringfügig im Vergleich zu anderen Gelenken eingeschränkt sind. Das Kugelgelenk weist ein an dem Wählhebel befestigtes Gehäuse und eine an der Halterung befestigte und in dem Gehäuse angeordnete Gelenkkugel auf, so dass das Gehäuse zusammen mit dem Wählhebel um die Gelenkkugel schwenkbar ist.

Die Sensoren sind in dem Gehäuse und der Signalgeber in der Gelenkkugel angeordnet, welche hierfür eine Ausnehmung aufweisen kann in welcher der Signalgeber sitzt. Ferner kann die Halterung einstückig mit der Gelenkkugel ausgebildet werden und z.B. ein Stahlträger sein.

Die Gelenkkugel kann aus einem ferromagnetischen Material bestehen. In diesem Fall ist es günstig, den in der Gelenkkugel sitzenden Signalgeber in ein nicht-magnetisches Material, wie z.B. Aluminium oder Kunststoff, einzubetten. Hierdurch werden die Eigenschaften des Magnetfelds hinsichtlich der Signalerfassung in positiver Weise beeinflusst, falls der Signalgeber ein Magnet bzw. Permanentmagnet ist.

Zur Festlegung bzw. Vorgabe der möglichen Bewegungen des Wählhebels kann eine Schaltkulisse mit einer oder mehreren Schaltgassen vorgesehen sein, durch welche hindurch sich der Wählhebel erstreckt und entlang welcher der Wählhebel bewegbar ist. Die Schaltkulisse ist dabei bevorzugt unmittelbar oder mittelbar mit der Halterung verbunden bzw. an dieser festgelegt. Insbesondere liegen alle von den Schaltgassen der Schaltkulisse vorgegebenen Wählhebelstellungen einschließlich aller Zwischenstellungen innerhalb des Erfassungsbereichs der Winkelmessvorrichtung bzw. der Sensoren, so dass neben den vorgegebenen Wählhebelstellungen auch alle Zwischenstellungen von der Winkelmessvorrichtung erfasst werden können. Zur einfacheren Bedienung kann der Wählhebel ein freies Ende aufweisen, an dem ein Schaltknauf befestigt ist.

Das Kraftfahrzeuggetriebe ist insbesondere in unterschiedliche Schaltzustände stellbar, wobei die mit den Sensoren elektrisch verbundene Steuereinrichtung die von den Sensoren abgegebenen elektrischen Signale auswerten und das Getriebe in Abhängigkeit von dieser Auswertung in unterschiedliche Schaltzustände stellen kann. Da der Abstand der Sensoren zu dem Signalgeber ein Maß für die Stellung des Wählhebels im Raum ist, wird durch die Auswertung die aktuelle Lage des Wählhebels bestimmt. Diese Auswertung erfolgt insbesondere kontinuierlich oder quasi kontinuierlich. Ferner ist es möglich, nicht nur die absolute Lage des Wählhebels im Raum sondern auch die Geschwindigkeit zu ermitteln, mit welcher der Wählhebel von dem Anwender bewegt wird. Hierzu kann die Steuereinrichtung einen z.B. analogen oder digitalen Differentiator aufweisen, der die Geschwindigkeit des Wählhebels durch zeitliche Ableitung der durch die Auswertung ermittelten Orts- bzw. Winkelkoordinaten des Wählhebels bestimmt.

Die der Erfindung zu Grunde liegende Aufgabe wird ferner durch ein Kraftfahrzeug mit einer erfindungsgemäßen Schaltvorrichtung gelöst, wobei die Halterung am Kraftfahrzeug bzw. am Fahrzeugaufbau, insbesondere im Innern der Kraftfahrzeugs, z.B. im Fahrgastinnenraum, befestigt ist. Die Schaltvorrichtung kann dabei gemäß aller zuvor genannten Ausgestaltungen weitergebildet sein. Ferner ist es möglich, die Steuereinrichtung mit einer Motor-Getriebe-Steuerung zu koppeln oder in diese zu integrieren.

Die Erfindung betrifft ferner die Verwendung einer erfindungsgemäßen Schaltvorrichtung zum Betätigen des in einem Kraftfahrzeug angeordneten und in unterschiedliche Schaltzustände stellbaren Getriebes, wobei die Sensoren mit dem Signalgeber zusammenwirken und elektrische Signale an die Steuereinrichtung abgeben und wobei von der Steuereinrichtung die elektrischen Signale zu einer Wählhebelstellung ausgewertet werden, wobei das Getriebe in Abhängigkeit von der Wählhebelstellung in einen der Schaltzustände gestellt wird. Die Schaltvorrichtung kann dabei gemäß aller zuvor genannten Ausgestaltungen weitergebildet werden.

Ferner kann, wie oben bereits angesprochen, bei einer Betätigung des Wählhebels dessen Betätigungsgeschwindigkeit ermittelt werden, indem von der Steuereinrichtung die z. B. kontinuierlich oder quasi kontinuierlich ermittelten Orts- oder Winkelkoordinaten des Wählhebels nach der Zeit differenziert werden.

Mit Hilfe der Integration von intelligenter Winkelsensorik in das Kugelgelenk, mit dem der Schalt- bzw. Wählhebel des Getriebes gelagert wird, erfolgt eine Positionsbestimmung des Wählhebels und somit der Fahrervorgabe für das Getriebe. Bei dem magnetoresistiven Messprinzip wird z. B. die Feldlinienrichtung des als kalibrierten Magneten ausgebildeten Signalgebers in der als Stahlträger ausgebildeten Halterung relativ zur Sensorbaugruppe bzw. zu den Sensoren gemessen, so dass die Erfassung einer Relativdrehung zwischen Magnet und Sensorbaugruppe bzw. Sensoren in einem großen Winkelbereich hochauflösend möglich ist.

Die Positionsbestimmung der Wählhebelstellung ist flexibel in einer von zwei Koordinaten aufgespannten Fläche möglich, so dass von der Sensorik gleichzeitig zwei kardanische Winkel des Kugelgelenks erfasst werden können. Die Signalauswertung und Schaltstellungserkennung wird von der Steuereinrichtung durchgeführt, die im Gelenk oder außerhalb des Gelenks, z. B. als ein extern angeordnetes elektronisches Modul zur kennfeldbasierten Signalfeldverarbeitung, angeordnet ist.

Für die Umsetzung individueller Schaltbilder, bei denen verschiedene stabile und instabile Schalthebelpositionen - also auch Zwischenstellungen - angefahren und erkannt werden sollen, erfolgt die Erfassung der Schalthebelstellung bevorzugt kontinuierlich und in einem entsprechend großem Winkelbereich. Neuartige Schaltbilder sehen beispielsweise einen Gassenwechsel (=2 Gassen) alleine schon im Automatikbereich (bislang eine Gasse) vor, um ein Überspringen der Stufe P (Parken) beim Schalten von D (Drive) nach R (Reverse) zu vermeiden, woraus sich ein Vorteil bei der Bediensicherheit ergibt. Dazu könnte noch eine manuelle Zusatzgasse kommen (= 3 Gassen in Summe), woraus eine komplexe Führung des Wählhebels resultiert.

Zusätzlich kann durch integrierte numerische oder analoge Differenzation die Betätigungsgeschwindigkeit des Wählhebels zu adaptiven Zwecken für die Motor-Getriebe-Steuerung oder weitere Antriebs- und Fahrwerksregelsysteme z. B. von der Steuereinrichtung, insbesondere als elektrisches Signal ausgegeben werden.

Mit lediglich zwei integrierten Sensoren bzw. einer integrierten Sensorbaugruppe zur Erfassung sämtlicher ebener Wählhebellagen lassen sich neben der größeren Flexibilität bei komplexer Kulissenausführung sowohl Kosten- als auch Zuverlässigkeitsvorteile darstellen. Für neuartige Shift-by-wire-Systeme sind räumlich nicht geführte Schalthebelbewegungen denkbar, die mit herkömmlicher Lagesensorik nur schwierig, mit der erfindungsgemäßen Schaltvorrichtung aber problemlos zu erfassen sind. Die Bestimmung der Position kann in einem aufgespannten Feld mit Hilfe von zwei im Gehäuse orthogonal zueinander angebrachten Sensoren kontinuierlich bestimmt werden.

Somit ist es möglich, ein "intelligentes" Gelenk zu bilden, bei dem die Winkelmessvorrichtung, gegebenenfalls zusammen mit der Steuereinrichtung, in das Gelenk integriert ist, welche nicht nur den Ort des Wählhebels sondern auch die Bewegungsgeschwindigkeit des Wählhebels, z.B. durch numerische Differentiation, ermitteln kann. Somit können die Schaltdynamik beschreibende Zusatzsignale zur Adaption der Getriebesteuerung, z.B. Sport- bzw. Komfortbetrieb, genutzt werden.

Die Erfindung wird nachfolgend anhand einer bevorzugten Ausführungsform unter Bezugnahme auf die Zeichnung beschrieben. In der Zeichnung zeigen:

Fig. 1   eine schematische Darstellung einer Ausführungsform der erfindungsgemäßen Wählhebelanordnung,
Fig. 2   eine schematische Darstellung des Messbereichs der Ausführungsform nach Fig.1,
Fig. 3   eine schematische Darstellung eines Kraftfahrzeugs mit der erfindungsgemäßen Wählhebelanordnung,
Fig. 4   ein schematisches Blockschaltbild eines analogen Differentiators,
Fig. 5   eine schematische Ansicht der Sensorbaugruppe nach Fig.1 und
Fig. 6   eine teilweise Schnittansicht der Ausführungsform.

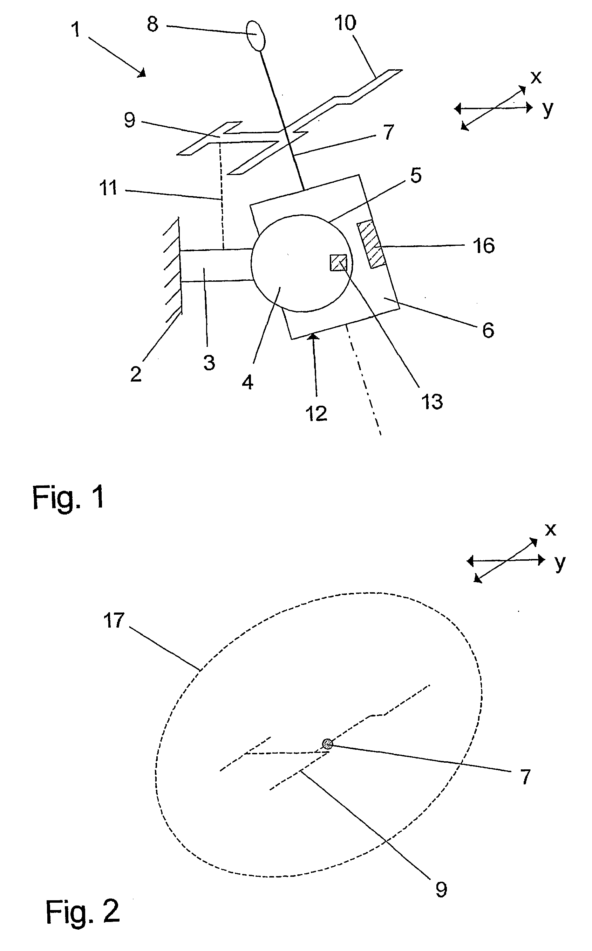

Aus Fig.1 ist eine Ausführungsform der erfindungsgemäßen Wählhebelanordnung ersichtlich, die insgesamt mit 1 bezeichnet wird. An einem schematisch dargestellten Kraftfahrzeug 2 ist eine als Stahlträger ausgebildete Halterung 3 befestigt, an der wiederum eine Gelenkkugel 4 festgelegt ist. Die Gelenkkugel 4 ist in einer sphärischen Ausnehmung 5 eines Gehäuses 6 derart gelagert, dass dieses um die Gelenkkugel 4 schwenken kann. An dem Gehäuse 6 ist ein Wählhebel 7 befestigt, an dessen dem Gehäuse 6 abgewandten Ende ein Schaltknauf 8 festgelegt ist. Der Wählhebel 7 erstreckt sich durch Schaltgassen 9 einer Schaltkulisse 10 hindurch, wobei der Wählhebel 7 entlang der Schaltgassen 9 bewegbar ist. Durch eine gestrichelte Linie 11 ist angedeutet, dass die Schaltkulisse 10 an der Halterung 3 befestigt ist. Die Schaltkulisse 10 beschränkt somit den Bewegungsraum des Wählhebels 7 auf Bewegungen innerhalb Schaltgassen 9.

Ohne Schaltkulisse 10 wäre der Wählhebel 7 frei entlang der durch x und y gekennzeichneten Richtungen bewegbar, wobei allerdings auch hier die bauliche Ausgestaltung des durch die Gelenkkugel 4 und das Gehäuse 6 gebildeten Kugelgelenks 12 den Bewegungsraum des Wählhebels 7 einschränkt.

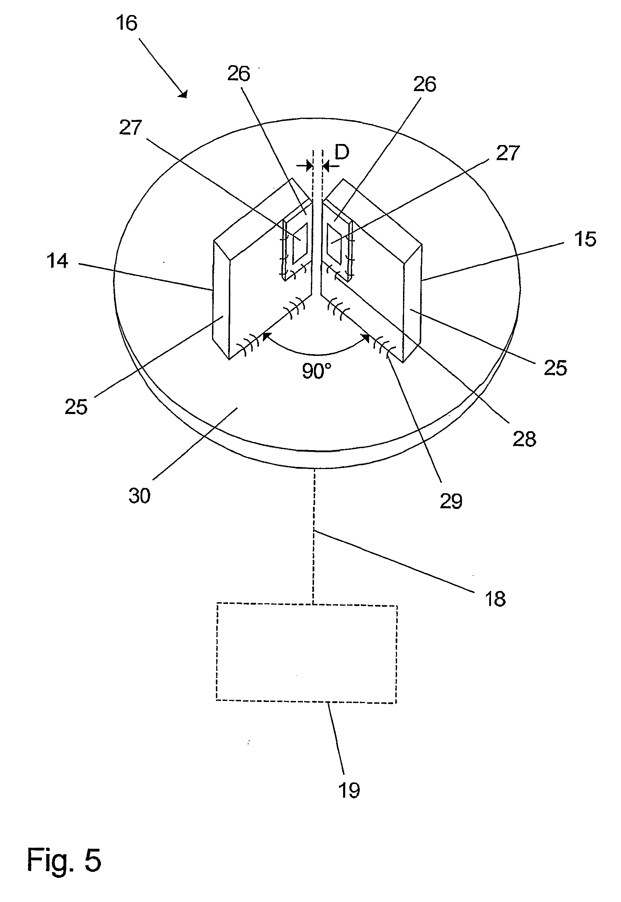

In der Gelenkkugel 4 ist ein Permanentmagnet 13 angeordnet, dessen Magnetfeld mit zwei Sensoren 14 und 15 (siehe Fig. 5) zusammenwirkt, die zu einer Sensorbaugruppe 16 zusammengefasst und in dem Gehäuse 6 angeordnet sind. Die beiden Sensoren 14 und 15 sind dabei als magnetoresistive Sensoren ausgebildet.

Aus Figur 2 ist eine schematische Ansicht des Bewegungsraumes des Wählhebels 7 ersichtlich, der sich entlang der gestrichelt dargestellten Schaltgasse 9 bewegen kann. Der Bewegungsraum liegt dabei vollständig innerhalb des Messbereichs 17 der Winkelmessvorrichtung bzw. der Sensoren 14 und 15, so dass jede Position des Wählhebels in den Schaltgassen 9 eindeutig von den Sensoren 14 und 15 erfasst werden kann. Der Messbereich 17 berücksichtigt in diesem Fall bereits den Abstand der Kulisse 10 vom Kugelgelenk 12. Die Erfassung der Wählhebelstellung bzw. Wählhebelposition erfolgt dabei derart, dass die Sensoren 14 und 15 bei unterschiedlichen Wählhebelstellungen einen unterschiedlichen Abstand zu dem Magneten 13 aufweisen und sich somit auch an unterschiedlichen Orten des von dem Magneten erzeugten Magnetfelds befinden. Somit liefern die Sensoren 14 und 15 für unterschiedliche Wählhebelstellungen unterschiedliche elektrische Signale, anhand derer die jeweilige Wählhebelposition eindeutig bestimmbar ist. Eine Möglichkeit der Auswertung besteht z. B. darin, dass die Steuereinrichtung die von den Sensoren abgegebenen Signale mit in einem Speicher abgelegten Mustersignalen vergleicht, die zuvor für jede Schalthebelstellung ermittelt wurden.

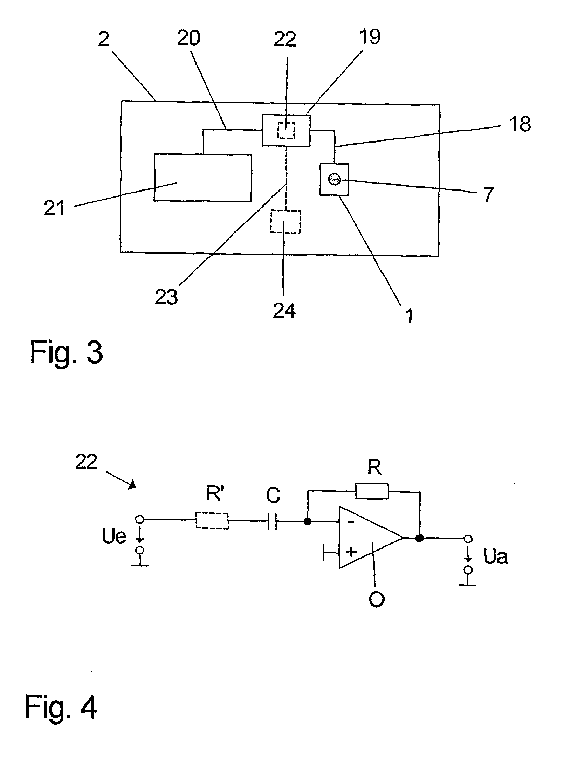

Aus Fig. 3 ist eine schematische Ansicht des Kraftfahrzeugs 2 ersichtlich, welches eine über elektrische Leitungen 18 elektrisch mit den Sensoren 14 und 15 verbundene Steuereinrichtung 19 aufweist, die ihrerseits über eine Verbindung 20 mit einem in dem Kraftfahrzeug 2 angeordneten Getriebe 21 verbunden ist, welches in mehrere Schaltstellungen stellbar ist. Weist das Getriebe 21 eine elektronisch ansteuerbare Stellvorrichtung auf, so kann die Verbindung 20 durch elektrische Leitungen gebildet sein. Falls das Getriebe 21 lediglich mechanisch verstellbar ist, kann die Verbindung 20 auch durch eine mechanische Stellvorrichtung gebildet sein, welche von einem insbesondere in der Steuereinrichtung 19 ausgebildeten Aktuator betätigbar ist.

Die Steuereinrichtung 19 kann die von den Sensoren 14 und 15 abgegebenen elektrischen Signale unterschiedlichen Wählhebelstellungen zuordnen und das Getriebe 21 gemäß der ermittelten Wählhebelstellung über die Verbindung 20 in einen bestimmten Schaltzustand stellen. Ferner kann die Steuereinrichtung 19 einen Differentiator 22 aufweisen, der die kontinuierlich oder quasi kontinuierlich ermittelten Positions- bzw. Winkelsignale, welche die Position des Wählhebels 7 repräsentieren, ableiten kann, um so die Geschwindigkeit zu ermitteln, mit welcher der Wählhebel 7 betätigt wird bzw. betätigt worden ist. Die die Wählhebelgeschwindigkeit repräsentierenden Daten bzw. elektrischen Signale können dann über eine elektrische Leitung 23 einer Motor-Getriebe-Steuerung 24 zugeführt werden.

Aus Figur 4 ist ein schematisches Blockschaltbild eines solchen Differentiators ersichtlich, wobei die zeitliche Ableitung der Eingangsspannung Ue proportional zur Ausgangsspannung Ua ist. Insbesondere gilt:

$$Ua = -RC\frac{dUe}{dt} \text{ für Frequenzen } f << \frac{1}{2\pi R'C}$$

Dabei repräsentiert die Spannung Ue den Ort oder Winkel des Wählhebels bzw. die Wählhebelstellung, wohingegen die Spannung Ua die Betätigungsgeschwindigkeit des Wählhebels repräsentiert. Selbstverständlich ist es auch möglich, einen Digitalprozessor zur numerischen Differentiation zu verwenden. In diesem Fall ist der Differentiator 22 digital ausgebildet und weist z. B. einen digitalen Signalprozessor auf. Insbesondere kann für jeden Sensor ein separater Differentiator vorgesehen sein.

Aus Figur 5 ist eine schematische Ansicht der Sensorbaugruppe 16 ersichtlich, wobei die beiden Sensoren 14 und 15 jeweils einen Sensorträger 25 und ein Sensorelement 26 mit einer sensitiven Fläche 27 aufweisen. Die beiden Sensorträger 25 sind in einem Abstand D von z. B. 0,3 mm zueinander angeordnet, und schließen einen Winkel von 90° miteinander ein. Es ist aber auch möglich, den Abstand D bis auf 0 mm zu reduzieren. Ferner schließen die sensitiven Flächen 27 der Sensorelemente 26 einen rechten Winkel miteinander ein, oder anders gesagt, die beiden sensitiven Flächen 27 liegen auf Ebenen, die einen rechten Winkel miteinander einschließen.

Über elektrische Kontaktierungen 28 sind die Sensorelemente 26 mit dem jeweiligen Sensorträger 25 verbunden, der über elektrische Kontaktierungen 29 an einer Platine bzw. Leiterplatte 30 angeschlossen ist, auf der die beiden Sensorträger 25 sitzen.

Ferner sind an die Leiterplatte 30 die elektrischen Leitungen 18 angeschlossen, die sich bis zur Steuereinrichtung 19 hin erstrecken, welche ebenfalls mit in die Sensorbaugruppe 16 integriert ausgebildet sein kann. Im letzteren Fall können die Leitungen 18 als Leiterbahnen auf oder in der Platine 30 gebildet sein.

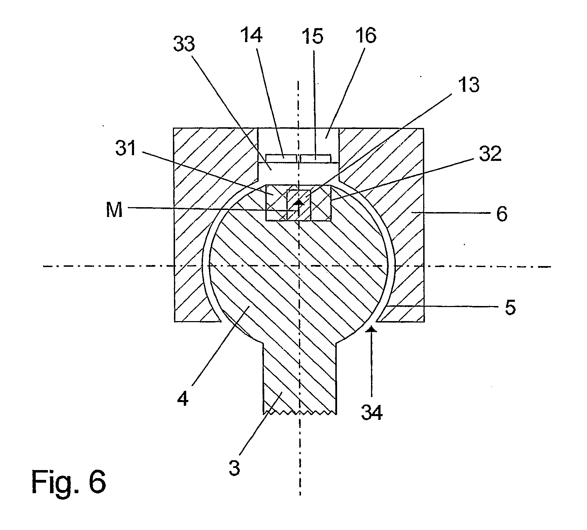

Aus Fig. 6 ist eine teilweise Schnittansicht der Ausführungsform ersichtlich, wobei der Magnet 13, dessen Magnetisierung mit M gekennzeichnet ist, in ein nicht-magnetisches Material 31 eingebettet ist und in einer in der Gelenkkugel 4 vorgesehenen Ausnehmung 32 sitzt. Ferner ist die Sensorbaugruppe 16 in einer in dem Gehäuse 6 vorgesehenen Ausnehmung 33 angeordnet. Der aus Gelenkkugel 4 und Halterung 3 gebildete Kugelzapfen, erstreckt sich durch eine Gehäuseöffnung 34 aus dem Gehäuse 6 heraus, wobei die Gelenkkugel 4 mit der Halterung 3 gemäß dieser Ausführungsform insbesondere einstückig hergestellt ist.

**Bezugszeichenliste**

| | |
|---|---|
| 1 | Wählhebelanordnung |
| 2 | Kraftfahrzeug |
| 3 | Halterung |
| 4 | Gelenkkugel |
| 5 | sphärische Ausnehmung im Gehäuse |
| 6 | Gehäuse |
| 7 | Wählhebel |
| 8 | Schaltknauf |
| 9 | Schaltgassen |
| 10 | Schaltkulisse |
| 11 | mechanische Verbindung zwischen Schalkulisse und Halterung |

12    Kugelgelenk
13    Permanentmagnet
14    Sensor
15    Sensor
16    Sensorbaugruppe
17    Messbereich der Winkelmessvorrichtung am Ort der Schaltkulisse
18    elektrische Leitungen
19    Steuereinrichtung
20    Verbindung zwischen Steuereinrichtung und Getriebe
21    Getriebe
22    Differentiator
23    elektrische Leitungen
24    Motor-Getriebe-Steuerung
25    Sensorträger
26    Sensorelement
27    sensitive Fläche
28    elektrische Kontaktierungen
29    elektrische Kontaktierungen
30    Leiterplatte
31    nicht-magnetisches Material
32    Ausnehmung in Gelenkkugel
33    Ausnehmung in Gehäuse
34    Öffnung in Gehäuse

D    Abstand zwischen den Sensorträgern
Ue    Eingangsspannung
Ua    Ausgangsspannung
R    elektrischer Widerstand
C    elektrischer Kondensator
R'    elektrischer Widerstand
O    Operationsverstärker
M    Magnetisierung des Magneten
x    Raumrichtung
y    Raumrichtung

**Patentansprüche**

1. Schaltvorrichtung für ein Kraftfahrzeug mit einer mit einem Kraftfahrzeuggetriebe (21) verbundenen Steuereinrichtung (19), wobei die Schaltvorrichtung eine Halterung (3) und einen über ein Kugelgelenk (12) schwenkbar an der Halterung (3) gelagerten Wählhebel (7) aufweist,
**gekennzeichnet durch**
eine einen Signalgeber (13) und zwei Sensoren (14, 15) aufweisende Winkel**messvorrichtung,** welche in dem Kugelgelenk (12) angeordnet und mit der Steuereinrichtung (19) elektrisch verbunden ist, wobei das Kugelgelenk (12) ein an dem **Wählhebel** (7) befestigtes Gehäuse (6) und eine an der Halterung (3) befestigte und in dem Gehäuse (6) gelagerte Gelenkkugel (4) aufweist, wobei das Gehäuse (6) zusammen mit dem Wählhebel (7) um die Gelenckugel (4) schwenkbar ist, und wobei der Signalgeber (13) in der Gelenkkugel (4) und die Sensoren (14, 15) in dem Gehäuse (6) angeordnet sind.

2. Schaltvorrichtung nach Anspruch 1,
**dadurch gekennzeichnet, dass**
der Signalgeber (13) ein Magnet ist und die Sensoren (14, 15) magnetfeldempfindliche Sensoren sind.

3. Schaltvorrichtung nach Anspruch 2,
**dadurch gekennzeichnet, dass**
die Sensoren (14, 15) magnetoresistive Sensoren sind.

4. Schaltvorrichtung nach einem der vorangehenden Ansprüche,

**dadurch gekennzeichnet, dass**
die beiden Sensoren (14, 15) rechtwinklig zueinander ausgerichtet sind.

5. Schaltvorrichtung nach einem der vorangehenden Ansprüche,
**dadurch gekennzeichnet, dass**
die beiden Sensoren (14, 15) zu einer Sensorbaugruppe (16) zusammengefasst sind.

6. Schaltvorrichtung nach einem der vorangehenden Ansprüche,
**dadurch gekennzeichnet, dass**
die Gelenkkugel (4) aus einem ferromagnetischen Material besteht und eine Ausnehmung (32) aufweist, in welcher der Signalgeber (13) sitzt, der in ein nicht-magnetisches Material (31) eingebettet ist.

7. Schaltvorrichtung nach einem der vorangehenden Ansprüche,
**dadurch gekennzeichnet, dass**
mit der Halterung (3) unmittelbar oder mittelbar eine Schaltkulisse (10) mit einer oder mehreren Schaltgassen (9) verbunden ist, durch welche hindurch sich der Wählhebel (7) erstreckt und entlang welcher der Wählhebel (7) bewegbar ist.

8. Schaltvorrichtung nach einem der vorangehenden Ansprüche,
**dadurch gekennzeichnet, dass**
der Wählhebel (7) ein freies Ende aufweist, an dem ein Schaltknauf (8) befestigt ist.

9. Schaltvorrichtung nach einem der vorangehenden Ansprüche,
**dadurch gekennzeichnet, dass**
das Getriebe (21) in unterschiedliche Schaltzustände stellbar ist, wobei von der elektrisch mit den Sensoren (14, 15) verbunden Steuereinrichtung (19) von den Sensoren (14, 15) abgegebene elektrische Signale auswertbar sind und das Getriebe (21) in Abhängigkeit von dieser Auswertung in unterschiedliche Schaltzustände stellbar ist.

10. Schaltvorrichtung nach einem der vorangehenden Ansprüche,
**dadurch gekennzeichnet, dass**
die Steuereinrichtung (19) einen Differentiator (22) aufweist.

11. Schaltvorrichtung nach einem der vorangehenden Ansprüche,
**dadurch gekennzeichnet, dass**
die Steuereinrichtung (19) in dem Kugelgelenk (12) angeordnet ist.

12. Kraftfahrzeug mit einer Schaltvorrichtung nach einem der vorangehenden Ansprüche,
**dadurch gekennzeichnet,** das
die Halterung (3) an dem Kraftfahrzeug (2) befestigt ist.

13. Kraftfahrzeug nach Anspruch 12,
**dadurch gekennzeichnet, dass**
der Wählhebel (7) im Inneren des Kraftfahrzeugs (2) angeordnet ist.

14. Kraftfahrzeug nach Anspruch 12 oder 13,
**dadurch gekennzeichnet, dass**
die Steuereinrichtung (19) in eine Motor-Getriebe-Steuerung (24) integriert ist.

15. Verwendung einer Schaltvorrichtung nach einem der Ansprüche 1 bis 11 zum Betätigen des in einem Kraftfahrzeug (2) angeordneten Getriebes (21), welches in unterschiedliche Schaltzustände gestellt werden kann, wobei
die Sensoren (14, 15) mit dem Signalgeber (13) zusammenwirken und elektrische Signale an die Steuereinrichtung (19) abgeben,
von der Steuereinrichtung (19) durch Auswertung der elektrischen Signale die Wählhebelstellung bestimmt wird und das Getriebe (21) von der Steuereinrichtung (19) in Abhängigkeit von der Wählhebelstellung in einen der Schaltzustände gestellt wird.

16. Verwendung nach Anspruch 15,
**dadurch gekennzeichnet, dass**

**EP 1 815 594 B1**

der Wählhebel (7) betätigt wird und von der Steuereinrichtung (19) die Betätigungsgeschwindigkeit des Wählhebels (7) durch analoge oder numerische Differentiation von den Wählhebelstellungen zugeordneten Signalen bestimmt wird.

**Claims**

1. Shifting apparatus for a motor vehicle, having a control device (19) which is connected to a motor-vehicle gearbox (21), wherein the shifting apparatus has a holding means (3) and a selector lever (7) which is mounted on the holding means (3) in a pivotable manner by means of a ball-and-socket joint (12), **characterized by** an angle-measuring apparatus which has a signal transmitter (13) and two sensors (14, 15), is arranged in the ball-and-socket joint (12) and is electrically connected to the control device (19), wherein the ball-and-socket joint (12) has a housing (6), which is attached to the selector lever (7), and a joint ball (4), which is attached to the holding means (3) and is mounted in the housing (6), wherein the housing (6) can be pivoted together with the selector lever (7) about the joint ball (4), and wherein the signal transmitter (13) is arranged in the joint ball (4) and the sensors (14, 15) are arranged in the housing (6).

2. Shifting apparatus according to Claim 1, **characterized in that** the signal transmitter (13) is a magnet, and the sensors (14, 15) are sensors which are sensitive to magnetic fields.

3. Shifting apparatus according to Claim 2, **characterized in that** the sensors (14, 15) are magnetoresistive sensors.

4. Shifting apparatus according to one of the preceding claims, **characterized in that** the two sensors (14, 15) are oriented at right angles to one another.

5. Shifting apparatus according to one of the preceding claims, **characterized in that** the two sensors (14, 15) are combined to form a sensor assembly (16).

6. Shifting apparatus according to one of the preceding claims, **characterized in that** the joint ball (4) is composed of a ferromagnetic material and has a recess (32) in which the signal transmitter (13) is seated, the said signal transmitter being embedded in a non-magnetic material (31).

7. Shifting apparatus according to one of the preceding claims, **characterized in that** a shift gate (10) with one or more shift lanes (9) is connected directly or indirectly to the holding means (3), the selector lever (7) extending through the said shift gate and it being possible for the selector lever (7) to move along the said shift gate.

8. Shifting apparatus according to one of the preceding claims, **characterized in that** the selector lever (7) has a free end to which a shifter knob (8) is attached.

9. Shifting apparatus according to one of the preceding claims, **characterized in that** the gearbox (21) can be moved to different shift states, wherein electrical signals which are emitted by the sensors (14, 15) can be evaluated by the control device (19) which is electrically connected to the sensors (14, 15), and the gearbox (21) can be moved to different shift states depending on this evaluation.

10. Shifting apparatus according to one of the preceding claims, **characterized in that** the control device (19) has a differentiator (22).

11. Shifting apparatus according to one of the preceding claims, **characterized in that** the control device (19) is arranged in the ball-and-socket joint (12).

12. Motor vehicle having a shifting apparatus according to one of the preceding claims, **characterized in that** the holding means (3) is attached to the motor vehicle (2).

13. Motor vehicle according to Claim 12, **characterized in that** the selector lever (7) is arranged in the interior of the motor vehicle (2).

14. Motor vehicle according to Claim 12 or 13, **characterized in that** the control device (19) is integrated in an engine/gearbox control means (24).

**EP 1 815 594 B1**

**15.** Use of a shifting apparatus according to one of Claims 1 to 11 for operating the gearbox (21) which is arranged in a motor vehicle (2) and can be moved to different shift states, wherein
the sensors (14, 15) interact with the signal transmitter (13) and output electrical signals to the control device (19),
the position of the selector lever is determined by the control device (19) by virtue of evaluating the electrical signals, and
the gearbox (21) is moved to one of the shift states by the control device (19) depending on the position of the selector lever.

**16.** Use according to Claim 15, **characterized in that** the selector lever (7) is operated, and the operating speed of the selector lever (7) is determined by the control device (19) by virtue of analogue or numerical differentiation of signals which are associated with the positions of the selector lever.

**Revendications**

**1.** Dispositif de changement de vitesse pour un véhicule automobile doté d'un dispositif de commande (19) relié à une boîte de vitesses de véhicule automobile (21), le dispositif de changement de vitesse comprenant un support (3) et un levier de changement de vitesse (7) disposé au niveau du support (3) de façon à pouvoir pivoter via une articulation sphérique (12), **caractérisé par** la présence d'un dispositif de mesure d'angle comportant un émetteur de signaux (13) et deux capteurs (14, 15), ledit dispositif étant disposé dans l'articulation sphérique (12) et étant relié sur le plan électrique au dispositif de commande (19), l'articulation sphérique (12) comportant un carter (6) fixé au levier de changement de vitesse (7) et une sphère articulée (4) fixée au support (3) et disposée dans le carter (6), le carter (6) pouvant pivoter autour de la sphère articulée (4) conjointement avec le levier de changement de vitesse (7) et l'émetteur de signaux (13) étant disposé dans la sphère articulée (4) et les capteurs (14, 15) étant disposés dans le carter (6).

**2.** Dispositif de changement de vitesse selon la revendication 1, **caractérisé en ce que** l'émetteur de signaux (13) est un aimant et que les capteurs (14, 15) sont des capteurs sensibles au champ magnétique.

**3.** Dispositif de changement de vitesse selon la revendication 2, **caractérisé en ce que** les capteurs (14, 15) sont des capteurs magnétorésistifs.

**4.** Dispositif de changement de vitesse selon l'une quelconque des revendications précédentes, **caractérisé en ce que** les deux capteurs (14, 15) sont orientés à angle droit l'un par rapport à l'autre.

**5.** Dispositif de changement de vitesse selon l'une quelconque des revendications précédentes, **caractérisé en ce que** les deux capteurs (14, 15) sont rassemblés en un module de détection (16).

**6.** Dispositif de changement de vitesse selon l'une quelconque des revendications précédentes, **caractérisé en ce que** la sphère articulée (4) est fabriquée en matière ferromagnétique et comporte un évidement (32) dans lequel repose l'émetteur de signaux (13) encastré dans une matière non magnétique (31).

**7.** Dispositif de changement de vitesse selon l'une quelconque des revendications précédentes, **caractérisé en ce qu'**un coulisseau de changement de vitesse (10) doté d'un ou de plusieurs couloirs de changement de vitesse (9) est relié de façon directe ou indirecte au support (3), le levier de changement de vitesse (7) s'étendant à travers ledit coulisseau et le levier de changement de vitesse (7) pouvant se déplacer le long dudit coulisseau.

**8.** Dispositif de changement de vitesse selon l'une quelconque des revendications précédentes, **caractérisé en ce que** le levier de changement de vitesse (7) comporte une extrémité libre fixée à un pommeau de changement de vitesse (8).

**9.** Dispositif de changement de vitesse selon l'une quelconque des revendications précédentes, **caractérisé en ce que** la boîte de vitesses (21) peut être placée dans différents états de changement de vitesse, les signaux électriques émis sur le plan électrique par le dispositif de commande (19) relié aux capteurs (14, 15) pouvant être analysés par les capteurs (14, 15) et la boîte de vitesses (21) pouvant être réglée dans différents états de changement de vitesse en fonction du résultat de cette analyse.

**10.** Dispositif de changement de vitesse selon l'une quelconque des revendications précédentes, **caractérisé en ce**

9

**que** le dispositif de commande (19) comporte un différenciateur (22).

11. Dispositif de changement de vitesse selon l'une quelconque des revendications précédentes, **caractérisé en ce que** le dispositif de commande (19) est disposé dans une articulation sphérique (12).

12. Véhicule automobile doté d'un dispositif de changement de vitesse selon l'une quelconque des revendications précédentes, **caractérisé en ce que** le support (3) est fixé au véhicule automobile (2).

13. Véhicule automobile selon la revendication 12, **caractérisé en ce que** le levier de changement de vitesse (7) est disposé à l'intérieur du véhicule automobile (2).

14. Véhicule automobile selon la revendication 12 ou 13, **caractérisé en ce que** le dispositif de commande (19) est intégré dans un élément de commande de boîte de vitesses de moteur (24).

15. Utilisation d'un dispositif de changement de vitesse selon l'une quelconque des revendications 1 à 11 servant à l'actionnement de la boîte de vitesses (21) disposée dans un véhicule automobile (2), ladite boîte de vitesses pouvant être placée dans différents états de changement de vitesse ;
les capteurs (14, 15) entrant en interaction avec l'émetteur de signaux (13) et envoyant des signaux électriques au dispositif de commande (19) ;
la position du levier de changement de vitesse étant définie par le dispositif de commande (19) par le biais de l'analyse des signaux électriques ;
la boîte de vitesses (21) étant placée dans un des états de changement de vitesse par le dispositif de commande (19) en fonction de la position du levier de changement de vitesse.

16. Utilisation selon la revendication 15, **caractérisée en ce que** le levier de changement de vitesse (7) est actionné et que la vitesse d'actionnement du levier de changement de vitesse (7) est définie par le dispositif de commande (19) par différentiation analogique ou numérique des signaux associés aux positions de levier de changement de vitesse.

Fig. 1

Fig. 2

**Fig. 3**

**Fig. 4**

Fig. 5

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4519266 A
- US 4733214 A
- EP 0357274 A
- DE 19749330 C2